Europäisches Patentamt

European Patent Office

Office européen des brevets

(11) Veröffentlichungsnummer: **0 525 246 A1**

## EUROPÄISCHE PATENTANMELDUNG

(21) Anmeldenummer: **91112957.5**

(22) Anmeldetag: **01.08.91**

(51) Int. Cl.5: **G01R 33/38**, G01R 33/40, G01R 33/42

(43) Veröffentlichungstag der Anmeldung:
**03.02.93 Patentblatt 93/05**

(84) Benannte Vertragsstaaten:
**DE**

(71) Anmelder: **SIEMENS AKTIENGESELLSCHAFT**
**Wittelsbacherplatz 2**
**W-8000 München 2(DE)**

(72) Erfinder: **Ries, Günter, Dr. Dipl.-Phys.**
**Schobertweg 2**
**W-8520 Erlangen(DE)**

(54) Magneteinrichtung mit einem ein magnetisches Streufeld erzeugenden Jochkörper.

(57) Die Magneteinrichtung (2) enthält in ihrem magnetischen Kreis einen weichmagnetischen Jochkörper (3), der einen von einer magnetfelderzeugenden Vorrichtung (7, 8) hervorgerufenen magnetischen Fluß ($\phi$) führt und ein magnetisches Streufeld ($H_s$) erzeugt. Zur Reduzierung dieses Streufeldes ist erfindungsgemäß vorgesehen, daß ein Teilstück (3c) des Jochkörpers (3) von einer Kompensationswicklung (13) umgeben ist, die elektrisch so erregt ist, daß in dem Jochkörper (3) zusätzlich zu dem von der Vorrichtung (7, 8) erzeugten Fluß ($\phi$) ein Zusatzfluß ($\phi'$) mit einer solchen Größe hervorgerufen ist, daß das zu dem Streufeld ($H_s$) führende magnetische Dipolmoment des Jochkörpers (3) zumindest teilweise kompensiert wird.

FIG 1

EP 0 525 246 A1

Die Erfindung bezieht sich auf eine Einrichtung mit einem magnetischen Kreis, in dem ein Jochkörper aus weichmagnetischem Material angeordnet ist, der einen von einer magnetfelderzeugenden Vorrichtung hervorgerufenen magnetischen Fluß führt und ein magnetisches Streufeld erzeugt. Eine derartige Magneteinrichtung geht z.B. aus der DE-OS 37 37 133 hervor.

Bei der bekannten Magneteinrichtung handelt es sich um einen Homogenfeldmagneten zur Erzeugung magnetischer Grundfelder in Anlagen zur Kernspintomographie (Nuclear-Magnetic-Resonance-Tomography, -Imaging oder -Spectroscopy). Das Magnetfeld eines derartigen Grundfeldmagneten muß dabei in einem Abbildungs- bzw. Untersuchungsbereich (Nutzvolumen) hinreichend homogen sein und dort zu einer vorbestimmten magnetischen Induktion $B_o$ führen. Hierzu sind als magnetfelderzeugende Vorrichtung normalleitende Spulen oder Permanentmagnete vorgesehen, die an einem z.B. C-förmigen Jochkörper aus weichmagnetischem Material angeordnet sind. Dieser Jochkörper dient zur Führung des erzeugten magnetischen Flusses außerhalb des zwischen den Polflächen von gegenüberliegenden Polschuhen liegenden Nutzvolumens.

Mit einem derartigen Jochkörper kann zwar der magnetische Kreis weitgehend geschlossen werden; es zeigt sich jedoch, daß ein solcher Jochkörper ein magnetisches Streufeld verursacht, das verhältnismäßig weitreichend ist. Solche Streufelder sind insbesondere im Falle der Kernspintomographie unerwünscht.

Aufgabe der vorliegenden Erfindung ist es deshalb, die Magneteinrichtung mit den eingangs genannten Merkmalen dahingehend auszugestalten, daß die Reichweite des von dem Jochkörper verursachten Streufeldes verringert wird.

Diese Aufgabe wird erfindungsgemäß dadurch gelöst, daß ein Teilstück des Jochkörpers von einer Kompensationswicklung umgeben ist, die elektrisch so erregt ist, daß in dem Jochkörper zusätzlich zu dem von der Vorrichtung erzeugten magnetischen Fluß ein magnetischer Zusatzfluß mit solcher Größe hervorgerufen ist, daß das zu dem Streufeld führende magnetische Dipolmoment des Jochkörpers zumindest teilweise kompensiert wird.

Die Erfindung geht dabei von der Erkenntnis aus, daß das weichmagnetische Material des Jochkörpers aufgrund des endlichen Wertes der relativen Permeabilität $\mu_r$ in der Größenordnung von z.B. 1000 einen magnetischen Widerstand für den magnetischen Fluß bildet. Dieser magnetische Widerstand zeigt sich in Form eines magnetischen Dipolmomentes des Jochkörpers und ist als Hauptquelle des Streufeldes anzusehen. Mit den erfindungsgemäßen Maßnahmen wird nun erreicht, daß das magnetische Moment des Jochkörpers durch ein entgegengesetzes Moment einer stromdurchflossenen Spule zumindest zu einem Teil kompensiert wird. Die damit verbundenen Vorteile sind insbesondere in einer entsprechenden Verringerung der Reichweite des Streufeldes des Jochkörpers zu sehen. Auf diese Weise wird der Raum für einen unkontrollierten Zugang in der Umgebung der Magneteinrichtung, insbesondere in Räumen, die an eine entsprechende Kernspintomographieanlage angrenzen, nicht unnötig eingeschränkt.

Vorteilhafte Ausgestaltungen der Magneteinrichtung nach der Erfindung gehen aus den Unteransprüchen hervor.

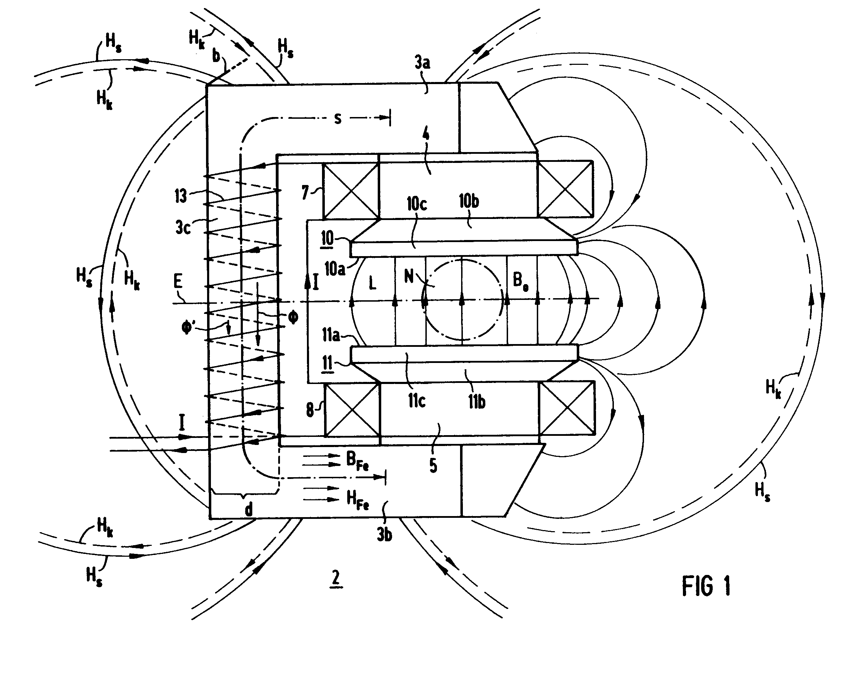

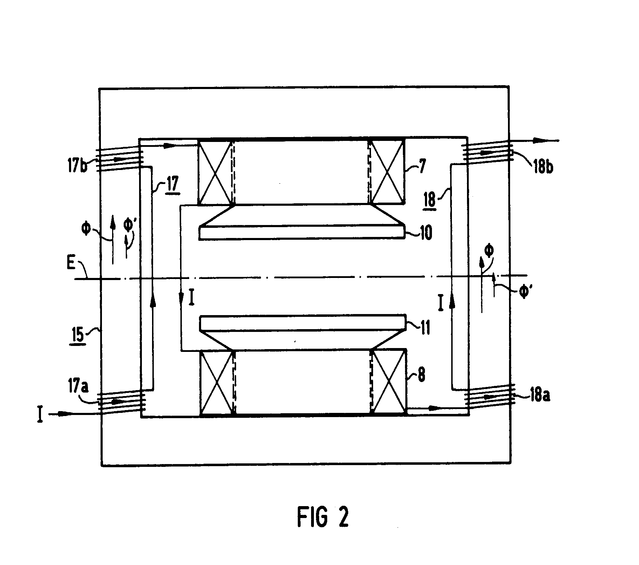

Die Erfindung wird nachfolgend anhand von Ausführungsbeispielen noch weiter erläutert, wobei auf die Zeichnung Bezug genommen wird. Dabei zeigt Figur 1 schematisch eine Ausführungsform einer erfindungsgemäßen Magneteinrichtung. Aus Figur 2 geht eine weitere Ausführungsform einer solchen Magneteinrichtung schematisch hervor. In den Figuren sind sich entsprechende Teile mit denselben Bezugszeichen versehen.

Bei einer erfindungsgemäßen Magneteinrichtung wird von bekannten Ausführungsformen mit einem weichmagnetischen Jochkörper ausgegangen. Hierbei kann es sich insbesondere um den Grundfeldmagneten einer Anlage zur Kernspintomographie handeln. Für das nachfolgende Ausführungsbeispiel sei eine entsprechende Magneteinrichtung ausgewählt, die in bekannter Weise (vgl. die genannte DE-OS 37 37 133) als Polschuhmagnet gestaltet ist.

Die allgemein mit 2 bezeichnete Magneteinrichtung weist einen einschenkligen Jochkörper 3 aus einem weichmagnetischen Material wie z.B. aus Eisen mit einer relativen Permeabilität $\mu_r$ von ungefähr 1000 auf. Die Magneteinrichtung wird vielfach auch wegen der Gestalt ihres Jochkörpers 3 als C-Magnet bezeichnet. Die beiden gegenüberliegenden freien Schenkelenden 3a bzw. 3b des Jochkörpers 3 münden jeweils in einen wenigstens annähernd zylinderförmigen Kern 4 bzw. 5 aus magnetischem Material. Diese aufeinander zuführenden Kerne sind dabei jeweils von einer eigenen Erregerspule 7 bzw. 8 umschlossen. An den den Schenkelenden 3a bzw. 3b abgewandten Seiten gehen die beiden Kerne 4 und 5 jeweils in einen Polschuh 10 bzw. 11 mit Polflächen 10a bzw. 11a über. Es ergibt sich so ein zu einer Symmetrieebene E zumindest weitgehend symmetrischer Aufbau der gesamten Magneteinrichtung.

Jeder der Polschuhe 10 und 11 setzt sich aus einem dem jeweiligen Kern 4 oder 5 zugewandten Basisteil 10b bzw. 11b sowie einer gegebenenfalls profilierten Polplatte 10c bzw. 11c zusammen. Zwischen den Polflächen 10a und 10b dieser Polplatten liegt ein Luftspalt L mit einem Nutzvolumen N. In diesem Nutzvolumen N soll ein zur Kernspintomographie hinreichend homogenes Magnetfeld herrschen, das von den beiden Erregerspulen 7 und 8 hervorgerufen wird. Mit normalleitenden Spulen ist dabei in dem Nutzvolumen eine durch gepfeilte Linien angedeutete magnetische Induktion $B_o$ zu erreichen, die insbesondere durch die Sättigungsmagnetisierung des Jochmaterials begrenzt ist und z.B. unter 0,5 T liegt.

Figur 1 zeigt ferner schematisch als durchgezogene, gepfeilte Linien die magnetischen Streufelder, welche vom Luftspalt L, den Erregerspulen 6 und 7 sowie dem Jochkörper 3 verursacht werden:

- Luftspalt L und Spulen 6 und 7 wirken als gegeneinander geschaltete magnetische Dipole gleicher Stärke, deren magnetische Fernfelder sich teilweise aufheben. Es bleiben nur höhere Multipolfelder übrig, die schnell mit $r^{-5}$, $r^{-7}$ usw. abfallen. r ist dabei die Entfernung von dem magnetfelderzeugenden Zentrum der Magneteinrichtung.

- Der magnetische Rückfluß $\phi$ wird zwar im Jochkörper 3 geführt. Das Eisen (Fe) als Jochkörpermaterial verursacht aber einen durch den endlichen Wert der Permeabilität $\mu_r$ bedingten magnetischen Widerstand, zu dessen Überwindung einige Prozent der von den Spulen 7 und 8 erzeugten Amperewindungen verbraucht werden. Im Eisen soll eine Flußdichte $B_{Fe}$ aufrechterhalten werden. Hierzu ist unter Berücksichtigung des magnetischen Widerstandes eine magnetische Feldstärke $H_{Fe}$ von den Erregerspulen 7 und 8 aufzubringen, wobei ein kleiner Anteil der Magnetfeldlinien als Streufeld aus dem Eisen in die es umgebende Luft gedrängt wird. Die Feldstärke $H_{Fe}$ muß wegen der zu fordernden Stetigkeit der Tangentialfeldstärke auch jenseits der Grenzfläche Luft/Fe in Luft herrschen. Die Folge davon ist eine Differenz $\int H_{Fe}{}^*ds$ des magnetischen Potentials zwischen der Ober- und der Unterseite des Jochkörpers längs eines Integrationsweges s. Dieser Integrationsweg s verläuft dabei in dem Jochkörper 3 in Flußführungsrichtung. Er stellt den Weg eines von den magnetischen Feldlinien über den Jochkörper geschlossenen magnetischen Kreises außerhalb der Bereiche dar, die von den Erregerspulen 7 und 8, den Polschuhen 10 und 11 sowie dem Luftspalt L eingenommen werden. Diese Differenz des magnetischen Potentials führt zu einem magnetischen Dipol. Dessen Fernfeld $H_s$ ist proportional zu dem Integral $\int H_{Fe}{}^*ds/r^3$ und fällt deshalb mit $r^{-3}$ ab. Dieses Fernfeld $H_s$ bildet den Hauptanteil des magnetischen Streufeldes des Jochkörpers 3.

Zu einer zumindest teilweisen Kompensation dieses Fernfeldes $H_s$ ist nach der Erfindung vorgesehen, das magnetische Dipolmoment des Jochkörpers 3 durch ein von einer stromdurchflossenen Kompensationswicklung 13 erzeugtes entgegengesetztes Moment entsprechend zu kompensieren. Diese Kompensationswicklung 13 umschließt den Jochkörper an einer beliebigen Stelle längs des Integrationsweges s, beispielsweise im Bereich des zwischen den Schenkelenden 3a und 3b senkrecht verlaufenden Jochbalkenteiles 3c. Zweckmäßig wird diese Wicklung in Serie mit den Erregerspulen 7 und 8 der Magneteinrichtung geschaltet. Die Feldlinien des auf die Kompensationswicklung 13 zurückzuführenden, das Streufeld $H_s$ kompensierenden Feldes sind in der Figur durch gestrichelte, mit $H_k$ bezeichnete Linien veranschaulicht.

Um eine Dimensionierung der Kompensationswicklung 13 abschätzen zu können, wird eine zur Betrachtung der magnetischen Momente gleichwertige Interpretation zugrundegelegt, daß nämlich diese Wicklung genähert als Flächenstromdichte J auf der Eisenoberfläche des Jochkörpers 3 angesehen werden kann. Dort wird ein Sprung der Größe J in der Tangentialfeldstärke $H_t$ verursacht, für die im Raum außerhalb des Eisens und der Wicklung zu fordern ist:

$$H_t = H_{Fe} - J = 0 .$$

Das Eisen erscheint dann von außen gesehen als ein Material mit einer unendlich hohen Permeabilität $\mu_r$. Mit dieser Bemessungsvorschrift kann die gesuchte Amperewindungszahl $n_k{}^*I$ der Kompensationswicklung 13 angegeben werden, wobei $n_k$ die Zahl der Windungen der Wicklung 13 und I der durch diese Wicklung fließende Strom sind:

$$\int J{}^*ds = n_k{}^*I = \int H_{Fe}{}^*ds \approx \langle H_{Fe} \rangle{}^*s .$$

Der Mittelwert $\langle H_{Fe} \rangle$ kann mit Hilfe einer numerischen Simulation errechnet oder aber auch mit einem Gaussmeter direkt an der Jochaußenfläche gemessen werden. Die durch eine strichpunktierte Linie veranschaulichte Strecke s umfaßt den Integrationsweg im Eisen des Jochkörpers 3 außerhalb des Spulenbereichs und des Nutzluftspaltes, d.h. den senkrechten Jochbalkenteil 3c sowie Teile des oberen und unteren Jochschenkels 3a bzw. 3b. Setzt man z.B. für einen C-Magneten zur Kernspintomographie für $s \approx 3$ m und $H_{Fe} \approx 11$ A/cm an, dann ergibt sich für die Kompensationswicklung 13 bei einem Erregerstrom von 300 A, wie er beispielsweise zur Erzeugung einer magnetischen Induktion $B_o$ von 0,3 T erforderlich ist:

$$n_k = 3300 \text{ A}/300 \text{ A} = 11 \text{ Windungen} .$$

An diese Wicklung 13 werden keine besonderen Genauigkeitsanforderungen gestellt; sie kann z.B. allein um den senkrechten Jochbalkenteil 3c gewickelt werden. Der Verzicht auf eine lokale Feldkompensation, d.h. $H_{Fe} \neq J$, hat nur höhere, räumlich schnell abfallende Multikomponenten im Streufeld zur Folge.

Die Windungen der Kompensationswicklung 13 umlaufen den magnetischen Kreis in derselben Richtung (mit demselben Wickelsinn) wie die der Erregerspulen 6 und 7. Die erfindungsgemäßen Maßnahmen bedeuten dann letztlich nur, den Anteil der vom magnetischen Widerstand des Eisens verbrauchten Amperewindungen von den Erregerspulen wegzunehmen und entlang dem Jochkörper 3 zu verteilen. Der hierfür erforderliche, in dem Jochkörper 3 von der Kompensationswicklung 13 hervorgerufene zusätzliche Magnetfluß ist in der Figur mit $\phi'$ bezeichnet. Er ist in dieselbe Richtung gerichtet wie der von den Erregerspulen 7 und 8 hervorgerufene Fluß $\phi$. Es entsteht also kein zusätzlicher Bedarf an Erregerleistung. Der Wert $n_k{}^*I$ hängt folglich nur vom Sättigungsgrad des Eisens, nicht aber von der Grundfeldstärke der Magneteinrichtung ab.

Aufgrund der erfindungsgemäßen Verwendung einer Kompensationswicklung 13 ist es gegebenenfalls sogar möglich, den flußführenden Querschnitt des Jochkörpers 3 und damit vorteilhaft die Eisenmasse ohne wesentliche Zunahme des Streufeldes zu reduzieren, wenn die Amperewindungen der Kompensationswicklung entsprechend erhöht werden. Die nachstehende Tabelle zeigt einige Beispiele für eine erfindungsgemäße 0,3 T-Magneteinrichtung 2 gemäß Figur 1 mit einem Jochkörper 3 aus Eisen mit der Firmenbezeichnung St 37 und einem Kohlenstoffgehalt unter 0,21 %. Bei den Größen b und d handelt es sich um die in der Figur nur angedeutete Breite bzw. um die Dicke (seitliche Ausdehnung) des Jochkörpers 3 im Bereich seines senkrechten Jochbalkens 3c.

Tabelle

| b*d (m²) | 1,1*0,3 | 1,1*0,25 | 1,1*0,23 | 1*0,23 |
|---|---|---|---|---|
| Eisenmasse (to) | 11,9 | 10,1 | 9,4 | 8,8 |
| $B_{Fe}$ (Tesla) | 1,25 | 1,5 | 1,63 | 1,8 |
| $H_{Fe}$ (A/cm) | 11 | 25 | 50 | 100 |
| $n_k{}^*I$ (Awdg) | 3300 | 7500 | 15000 | 30000 |
| $n_k$ bei I = 300 A | 11 | 25 | 50 | 100 |

Gemäß dem Ausführungsbeispiel nach Figur 1 wurde davon ausgegangen, daß der Jochkörper 3 der Magneteinrichtung 2 einen einzigen flußtragenden Jochbalken aufweist, der senkrecht zwischen einem oberen und einem unteren Schenkelteil zur Aufnahme der Polstücke und Erregerspulen verläuft. Die erfindungsgemäßen Maßnahmen sind jedoch nicht auf solche Ausführungsformen von Jochkörpern beschränkt. Vielmehr können auch Jochkörper mit mindestens zwei flußtragenden Jochbalken vorgesehen werden. Hierbei muß um jeden Jochbalken eine Kompensationswicklung mit derselben Anzahl von Amperewindungen angebracht werden. Ein entsprechendes Ausführungsbeispiel für eine Magneteinrichtung mit zwei Jochbalken, die auch als H-Magnet oder "Window-Frame-Magnet" bezeichnet wird, geht aus dem schematischen Querschnitt der Figur 2 hervor. Diese allgemein mit 15 bezeichnete Magneteinrichtung unterscheidet sich im wesentlichen von der Magneteinrichtung 2 der Figur 1 durch die Form ihres den magnetischen Fluß führenden Jochkörpers 16. Während nämlich der Jochkörper 3 der Magneteinrichtung 2 nach Figur 1 C-förmig ist, weist der Luftzwischenraum der Magneteinrichtung 15 H-Form auf. Der Vorteil eines C-Magneten ist in dem leichten Zugang zum Nutzvolumen, auch von der Seite her, zu sehen. Dagegen ist ein H-Magnet symmetrisch aufgebaut, so daß sich Verbiegungen seines Jochkörpers z.B. aufgrund von magnetischen Kräften oder durch thermische Dilatation weniger auf die Parallelität von Polflächen und somit auf die Homogenität auswirken. Außerdem ist seine Bauhöhe vergleichsweise geringer.

Wie ferner aus Figur 2 hervorgeht, sind wegen des symmetrischen Aufbaus um die beiden senkrechten Jochbalken 16a und 16b des Jochkörpers 16 zwei Teilwicklungen 17 bzw. 18 einer Kompensationswicklung gelegt. Jede Teilwicklung kann dabei in zwei oder mehr kompakte Wickelpakete 17a, 17b bzw. 18a, 18b pro Jochbalken unterteilt sein. Auch bei dieser Ausführungsform der Magneteinrichtung 15 sind die Teilwicklungen 17 und 18 in Reihe mit den Erregerspulen 7 und 8 geschaltet. Die Stromflußrichtungen des durch diese Teilwicklungen und die Erregerspulen fließenden Erregerstromes I sind dabei durch Pfeile veranschaulicht. Der Wickelsinn und damit die Stromflußrichtungen durch die Teilwicklungen 17 und 18 müssen wiederum so gewählt werden, daß von diesen Teilwicklungen in dem jeweiligen Jochbalken 16a oder 16b ein zusätzlicher magnetischer Fluß $\phi$ erzeugt wird, der in die gleiche Richtung wie der von den Erregerspulen 7 und 8 in dem jeweiligen Jochbalken hervorgerufene Magnetfluß $\phi$ weist.

Die erfindungsgemäßen Maßnahmen sind nicht nur auf eine Anwendung der Magneteinrichtung in einer Anlage zur Kernspintomographie beschränkt. Vielmehr können sie überall dort eingesetzt werden, wo eine Reduzierung eines von einem Jochkörper hervorgerufenen, unerwünschten magnetischen Streufeldes gefordert wird. Entsprechend zu reduzierende Streufelder können z.B. von Transformatorenkernen oder vom Eisenjoch eines Strahlführungsmagneten in einer Beschleunigungsanlage erzeugt werden.

**Patentansprüche**

1. Einrichtung mit einem magnetischen Kreis, in dem ein Jochkörper aus weichmagnetischem Material angeordnet ist, der einen von einer magnetfelderzeugenden Vorrichtung hervorgerufenen magnetischen Fluß führt und ein magnetisches Streufeld erzeugt, **dadurch gekennzeichnet,** daß ein Teilstück (3c; 16a, 16b) des Jochkörpers (3, 16) von einer Kompensationswicklung (13; 17, 18) umgeben ist, die elektrisch so erregt ist, daß in dem Jochkörper (3; 16) zusätzlich zu dem von der Vorrichtung (7, 8) erzeugten magnetischen Fluß ($\phi$) ein magnetischer Zusatzfluß ($\phi'$) mit einer solchen Größe hervorgerufen ist, daß das zu dem Streufeld ($H_s$) führende magnetische Dipolmoment des Jochkörpers (3, 16) zumindest teilweise kompensiert wird.

2. Einrichtung nach Anspruch 1, **dadurch gekennzeichnet,** daß die Kompensationswicklung aus mehreren Teilwicklungen (17, 18) besteht.

3. Einrichtung nach Anspruch 2, **dadurch gekennzeichnet,** daß jede Teilwicklung (17, 18) aus mindestens zwei Wickelpaketen (17a, 17b bzw. 18a, 18b) besteht.

4. Einrichtung nach einem der Ansprüche 1 bis 3, **dadurch gekennzeichnet,** daß die magnetfelderzeugende Vorrichtung mindestens ein Permanentmagnet ist.

5. Einrichtung nach einem der Ansprüche 1 bis 3, **dadurch gekennzeichnet,** daß die magnetfelderzeugende Vorrichtung mindestens eine elektrische Erregerspule (7, 8) ist.

6. Einrichtung nach Anspruch 5, **dadurch gekennzeichnet,** daß die Kompensationswicklung (13; 17, 18) in Reihe mit der mindestens einen Erregerspule (7, 8) geschaltet ist.

7. Einrichtung nach einem der Ansprüche 1 bis 6, **dadurch gekennzeichnet,** daß der Jochkörper (3, 16) C- oder H-Form aufweist.

8. Verwendung der Einrichtung nach einem der Ansprüche 1 bis 7 als Homogenfeldmagnet zur Kernspintomographie.

FIG 1

FIG 2

Europäisches
Patentamt

**EUROPÄISCHER RECHERCHENBERICHT**

Nummer der Anmeldung

EP    91 11 2957
Seite 1

## EINSCHLÄGIGE DOKUMENTE

| Kategorie | Kennzeichnung des Dokuments mit Angabe, soweit erforderlich, der maßgeblichen Teile | Betrifft Anspruch | KLASSIFIKATION DER ANMELDUNG (Int. Cl.5 ) |
|---|---|---|---|
| Y | US-A-4 724 412 (A.K. KALAFALA) <br> * Spalte 1, Zeile 53 - Spalte 2, Zeile 46 * <br> --- | 1-3,5,8 | G01R33/38 <br> G01R33/40 <br> G01R33/42 |
| Y | EP-A-0 424 808 (KABUSHIKI KAISHA TOSHIBA) <br> * Spalte 2, Zeile 49 - Spalte 4, Zeile 1 * <br> * Spalte 8, Zeile 15 - Spalte 10, Zeile 48; Abbildungen 7-9 * | 1-3,5,8 | |
| A | | 4,7 | |
| A | JAPANESE JOURNAL OF APPLIED PHYSICS. <br> Bd. 15, Nr. 9, 1. September 1976, TOKYO JP <br> Seiten 1695 - 1702; <br> K. TSUNO ET AL.: 'EFFECT OF RADIUS OF YOKE CURVATURE ON LEAKAGE FLUX OUTSIDE THE YOKE IN PERMANENT MAGNET ASSEMBLIES' <br> * das ganze Dokument * <br> --- | 1,4,7,8 | |
| A | REVIEW OF SCIENTIFIC INSTRUMENTS. <br> Bd. 57, Nr. 3, 1. März 1986, NEW YORK US <br> Seiten 393 - 403; <br> A. BIELECKI ET AL.: 'ZERO-FIELD NMR AND NQR SPECTROMETER' <br> * ABSCHNITT "I.D. A PRACTICAL TECHNIQUE" * <br> --- | 1,2,5,8 | |
| A | GB-A-2 232 771 (ELSCINT LTD.) <br> * Seite 2, Zeile 5 - Seite 6, Zeile 2; Abbildungen 2,4 * <br> --- | 1-3,8 | |
| A | FR-A-2 562 785 (COMMISSARIAT A L'ENERGIE ATOMIQUE) <br> * Seite 15, Zeile 8 - Seite 17, Zeile 4 * <br> * Seite 20, Zeile 3 - Zeile 15 * <br> * Seite 20, Zeile 22 - Zeile 35; Abbildungen 4,5 * <br> --- | 1-4,7,8 | |
| A | DE-A-3 719 306 (BRUKER ANALYTISCHE MESSTECHNIK GMBH) <br> * Spalte 2, Zeile 42 - Zeile 59 * <br> * Spalte 7, Zeile 1 - Zeile 41; Abbildung 4 * <br> --- | 1-4,7,8 | |

**RECHERCHIERTE SACHGEBIETE (Int. Cl.5 )**

G01R
H01F

Der vorliegende Recherchenbericht wurde für alle Patentansprüche erstellt

| Recherchenort | Abschlußdatum der Recherche | Prüfer |
|---|---|---|
| DEN HAAG | 19 MAERZ 1992 | HORAK G.I. |

KATEGORIE DER GENANNTEN DOKUMENTE

X : von besonderer Bedeutung allein betrachtet
Y : von besonderer Bedeutung in Verbindung mit einer
   anderen Veröffentlichung derselben Kategorie
A : technologischer Hintergrund
O : nichtschriftliche Offenbarung
P : Zwischenliteratur

T : der Erfindung zugrunde liegende Theorien oder Grundsätze
E : älteres Patentdokument, das jedoch erst am oder
   nach dem Anmeldedatum veröffentlicht worden ist
D : in der Anmeldung angeführtes Dokument
L : aus andern Gründen angeführtes Dokument
..........................................................................................
& : Mitglied der gleichen Patentfamilie, übereinstimmendes
   Dokument

EPO FORM 1503 03.82 (P0403)

Europäisches
Patentamt

EUROPÄISCHER RECHERCHENBERICHT

Nummer der Anmeldung

EP    91 11 2957
Seite 2

## EINSCHLÄGIGE DOKUMENTE

| Kategorie | Kennzeichnung des Dokuments mit Angabe, soweit erforderlich, der maßgeblichen Teile | Betrifft Anspruch | KLASSIFIKATION DER ANMELDUNG (Int. Cl.5 ) |
|---|---|---|---|
| A | WO-A-8 400 611 (W.H. OLDENDORF)<br>* Zusammenfassung *<br>* Seite 13, Zeile 34 - Seite 14, Zeile 17; Abbildung 2 *<br><br>----- | 1-4,7,8 | |
| | | | RECHERCHIERTE SACHGEBIETE (Int. Cl.5 ) |

Der vorliegende Recherchenbericht wurde für alle Patentansprüche erstellt

| Recherchenort | Abschlußdatum der Recherche | Prüfer |
|---|---|---|
| DEN HAAG | 19 MAERZ 1992 | HORAK G.I. |

KATEGORIE DER GENANNTEN DOKUMENTE

X : von besonderer Bedeutung allein betrachtet
Y : von besonderer Bedeutung in Verbindung mit einer
    anderen Veröffentlichung derselben Kategorie
A : technologischer Hintergrund
O : nichtschriftliche Offenbarung
P : Zwischenliteratur

T : der Erfindung zugrunde liegende Theorien oder Grundsätze
E : älteres Patentdokument, das jedoch erst am oder
    nach dem Anmeldedatum veröffentlicht worden ist
D : in der Anmeldung angeführtes Dokument
L : aus andern Gründen angeführtes Dokument
......................................................................................................
& : Mitglied der gleichen Patentfamilie, übereinstimmendes
    Dokument

EPO FORM 1503 03.82 (P0403)